(19) Europäisches Patentamt

European Patent Office

Office européen des brevets

(11) **EP 0 885 981 B1**

(12) **EUROPÄISCHE PATENTSCHRIFT**

(45) Veröffentlichungstag und Bekanntmachung des Hinweises auf die Patenterteilung:
**25.10.2006 Patentblatt 2006/43**

(51) Int Cl.:
*C23C 14/30* *(2006.01)*    *C23C 14/32* *(2006.01)*
*C23C 14/34* *(2006.01)*

(21) Anmeldenummer: **98110926.7**

(22) Anmeldetag: **15.06.1998**

(54) **Verfahren und Anlage zum Behandeln von Substraten mittels Ionen aus einer Niedervoltbogenentladung**

Process and apparatus for treating substrates by means of ions produced by low voltage arc discharge

Procédé et appareillage de traitement de substrats au moyen d'ions issus d'une décharge en arc à basse tension

(84) Benannte Vertragsstaaten:
**AT CH FR GB IT LI NL SE**

(30) Priorität: **16.06.1997 DE 19725930**

(43) Veröffentlichungstag der Anmeldung:
**23.12.1998 Patentblatt 1998/52**

(73) Patentinhaber: **Dr. Eberhard Moll GmbH**
**13407 Berlin (DE)**

(72) Erfinder: **Moll, Eberhard, Dr.**
**13407 Berlin (DE)**

(74) Vertreter: **Winter, Brandl, Fürniss, Hübner Röss, Kaiser,**
**Polte Partnerschaft Patent- und Rechtsanwaltskanzlei**
**Alois-Steinecker-Strasse 22**
**85354 Freising (DE)**

(56) Entgegenhaltungen:
**EP-A- 0 306 612**    **EP-A- 0 430 872**
**EP-A- 0 484 704**    **WO-A-94/14996**
**US-A- 4 555 611**

**Beschreibung**

Die voliegende Erfindung betrifft ein Verfahren zum Behandeln von Substraten mittels Ionen aus einer Niedervoltbogenentladung. Das Verfahren dient zur Vorbereitung von Gegenständen auf ein Beschichtungsverfahren und zur Beeinflussung des Schichtwachstums während dem Auftragen der Schicht. Die Gegenstände werden im folgenden als Substrate bezeichnet. Das erfindungsgemäße Verfahren eignet sich besonders für die Behandlung dreidimensional strukturierter Substrate, z.B. für die Behandlung von Werkzeugen, MaschinenbBauteilen oder Gebrauchsgegenständen vor und während der Beschichtung mit einer Verschleißschutzschicht.

Verschleißschutzschichten bestehen meist aus Nitriden, Carbiden oder Carbonitriden der Übergangselemente der 4., 5. und 6. Gruppe des periodischen Systems der Elemente. Als Übergangselemente werden die Elemente der Nebengruppen in der 3., 4. und 5. Periode bezeichnet. Es ist auch üblich, trockene Schmierschichten, z.B. Schichten aus Molybdändisulfid, als Deckschicht über einer Hartstoffschicht zu verwenden. Auf Maschinenbauteilen werden bevorzugt Metall und Wasserstoff enthaltende harte Kohlenstoffschichten aufgetragen.

Vakuumbeschichtungsverfahren, bei denen mindestens eine schichtbildende Atomsorte durch Atomisierung aus der kondensierten Phase in den Behandlungsraum gebracht wird, werden als physikalische Beschichtungsverfahren (physical vapour deposition, abgekürzt PVD) bezeichnet. Die wichtigsten PVD-Verfahren sind das Aufdampfen und die Kathodenzerstäubung, im folgenden kurz Zerstäubung (sputtering) genannt. Auch die im folgenden Abschnitt definierten reaktiven Aufdampf- und Zerstäubungsverfahren zählen, ungeachtet der dabei auftretenden chemischen Reaktionen, zu den PVD-Verfahren.

Es ist üblich, die Substrate vor der Beschichtung zu heizen, um adsorbierte Gase und Dämpfe zu entfernen. Das Heizen kann mit Hilfe von vakuumtauglichen Heizstrahlern oder auch mit einer Niedervoltbogenentladung erfolgen. Letztere wird dann bevorzugt, wenn Spulen zur Bündelung der Niedervoltbogenentladung vorhanden sind, da diese zugleich verwendet werden können, um die Gleichmäßigkeit der Erwärmung aller Substrate einer Charge zu bewirken (DE 3330144 bzw. US 4555611 und EP 0484704). Ein Nachteil dieser Heizmethode besteht darin, daß beim reaktiven Beschichten mit Hilfe von Funkenverdampfern nicht gleichzeitig geheizt werden kann. Der Grund sind die sich gegenseitig ausschließende Anforderungen an die Restgasatmosphäre.

Beim Heizen können Oxide entstehen. Oxidhäute mit einer Dicke von der Größenordnung einer viertel Lichtwellenlänge (etwa 0,1 $\mu$m) erkennt man mit bloßem Auge als sog. Anlauffarben. Um von den Oberflächen der Substrate und ihrer Halter Oxidhäute und andere unsichtbare Oberflächenschichten abzutragen, werden die Substrate mit positiv geladenen Ionen beschossen. Das Material an den Oberflächen wird dabei durch Zerstäubung abgetragen und auf den Wänden und Halterungen, aber auch auf den Substraten verteilt. Die Bilanz auf den Substraten ist negativ, d.h. man kann nach dem Ionenbeschuß eine Gewichtsabnahme messen. Es ist deshalb gerechtfertigt, diese Behandlung als "Ätzen" zu bezeichnen. Der Ausdruck "Reinigen" wäre nur mit Vorbehalt gerechtfertigt, da durch das Hinundherstäuben der Oberflächenschichten, des Substratmaterials und des von der vorhergehenden Charge auf den Haltern vorhandenen Schichtmaterials eine dünne Mischschicht erzeugt wird. Letztere scheint die Haftfestigkeit der anschließend aufgedampften Schicht zu erhöhen. Dieses Zerstäubungsätzen, im folgenden auch als Ionenätzen bezeichnet, ist eine Behandlung im Sinne der vorliegenden Erfindung.

Keine Behandlung im Sinne der vorliegenden Erfindung ist das sog. Plasmaätzen. Das Plasmaätzen unterscheidet sich grundlegend vom Zerstäubungsätzen bzw. Ionenätzen: Während beim Zerstäubungsätzen das Material eines "Targets" durch Ionen mit erhöhter (über der Sputter-Schwelle liegender) kinetischer Energie durch Impulsübertrag physikalisch abgetragen wird, reagiert beim Plasmaätzen ein durch eine Gasentladung aktiviertes Ätzgas chemisch mit dem Material und bildet eine Verbindung mit hohem Dampfdruck, die als Gas bzw. Dampf abgepumpt werden kann.

Die Druckschriften EP 05 10 340 A1 und DE 43 10 941 A1 beschreiben Plasmaätzverfahren zur Abtragung von Material mittels Wasserstoff. Der Wasserstoff beseitigt Sauerstoff und Kohlenstoff aus Oberflächenverunreiniguungen durch die Erzeugung von Wasser und Kohlenwasserstoffverbindungen. Obwohl zur Aktivierung des Ätzgases eine Niedervoltbogenentladung verwendet wird, handelt es sich nicht um eine Behandlung im Sinne der vorliegenden Erfindung.

Auch die Druckschrift DE 30 15 296 A1 beschreibt ein Plasmaätzverfahren zur Abtragung von Material mittels eines durch eine Niedervoltbogenentladung aktivierten Ätzgases. Obwohl zum Zwecke des anisotropen Ätzens ein niederenergetischer (unter der Sputter-Schwelle liegender) Ionenbeschuß ohne Zerstäubung stattfinden kann, handelt es sich nicht um eine Behandlung durch Sputterätzen bzw. Ioneneätzen im Sinne der vorliegenden Erfindung.

Da nur das Zerstäubungsätzen bzw. Ionenätzen eine Ätzbehandlung im Sinne der vorliegenden Erfindung ist, wird das Zerstäubungsätzen bzw. Ionenätzen im folgenden auch abgekürzt als Ätzen bezeichnet.

Insbesondere bei mechanischen Anwendungen werden extrem hohe Anforderungen nicht nur an die Haftfestigkeit, sondern auch an die Elastizität der Schicht gestellt. Diese Anforderungen können erfahrungsgemäß durch Ionenplattieren (ion plating, abgekürzt IP) erfüllt werden. Wir verwenden diesen Ausdruck für die Behandlung durch Beschuß der aufwachsenden Schicht während der Beschichtung mit Ionen. Er bewirkt eine Verdichtung der Schicht und eine durchaus erwünschte innere Druckspannung in der Schicht. Auch das Ionenplattieren ist eine Behandlung im Sinne der vorliegenden Erfindung.

Ein Niedervoltbogen ist eine Gasentladung zwischen einer in einer vom Anodenraum getrennten, mit diesem durch eine Öffnung verbundenen Kammer angeordneten Glühkathode und einer Anode. Während des Betriebes wird in die Glühkathodenkammer laufend ein Edelgas eingeführt, und der Anodenraum wird durch Pumpen unter einem für den vorgesehenen Prozeß hinreichenden Vakuum gehalten.

Ein bekanntes Verfahren zum Behandeln von Substraten mittels Ionen aus einer Niedervoltbogenentladung wird in der Patentschrift DE 2823876 beschrieben. Es handelt sich um ein Verdampfungsverfahren, bei dem das zu verdampfende Material mit Elektronen aus der Niedervoltbogenentladung beschossen wird.

Bei diesem Verfahren wird das zu verdampfende Material als Anode der Niedervoltbogenentladung geschaltet. Der Anodenraum wird so zum Verdampfungsraum. Die durch die genannte Öffnung eingeschnürte Entladung wird im Verdampfungsraum zusätzlich durch ein Magnetfeld auf die Anode geführt und (zur Erzielung einer für die Verdampfung hinreichenden Leistungsdichte auf der Oberfläche der Anode) gebündelt. Das verdampfende Material befindet sich als flüssige Schmelze oder als sublimierendes Granulat in einem oben offenen, gekühlten Tiegel. Die Führung und Bündelung wird durch ein Magnetfeld bewirkt, dessen Feldlinien parallel zur Entladung verlaufen und die Entladung von oben auf den Tiegel führen. Dieses Magnetfeld wird meist durch eine Magnetspule oder ein Magnetspulenpaar erzeugt. Die Achsen dieser Spulen sind dabei meist senkrecht auf den Tiegel gerichtet.

Die Substrathalterung besteht üblicherweise aus drehbaren Substrathaltern, den sogenannten Bäumchen. Sie werden so auf einem Kreis angeordnet, daß sie einen axialsymmetrischen Hohlraum bilden. Der Verlauf der magnetisch gebündelten Niedervoltbogenentladung führt durch diesen Hohlraum, meist entlang der Achse. Bei einer axialsymmetrischen Anordnung dieser Art genügt die Rotation der Bäumchen um ihre eigene Achse, um eine gleichmäßige Behandlung zu erzielen. Eine Rotation der gesamten Substrathalterung um die Achse des Hohlraums nach Art eines Karussells ist nicht nötig. Wenn allerdings auch nicht axialsymmetrisch wirkende Quellen, z.B. außerhalb des Hohlraums angebrachte Funkenverdampfer (arc sources) oder Kathodenzerstäubungsquellen, ermöglicht werden sollen, so ist es bekannt, die Bäumchen sowohl um die erwähnte Karussellachse als auch um die Bäumchenachse drehen zu lassen (siehe z.B. EP 306612).

Das Verfahren nach DE 2823876 eignet sich zur Herstellung von Nitriden, Carbiden oder Carbonitriden durch aktiviertes reaktives Aufdampfen (activated reactive evaporation, abgekürzt ARE) aus Metalldampf. Dieser wird durch die Elektronen der Niedervoltbogenentladung in einem so hohen Maße aktiviert, daß man von vornherein das reine Metall verdampft und alle Stickstoff- und/oder Kohlenstoffatome aus einem Gas entnimmt. Die Glühkathode des Niedervoltbogens ist in ihrer Kammer so gut gegen Reaktivgase im Anodenraum geschützt, daß sogar Sauerstoff zur Herstellung von Oxidschichten eingelassen werden kann (DE 3543316, EP 0430872). Kombiniert man das ARE mit dem IP, so erhält man das aktivierte reaktive Ionenplattieren (activated reactive ion plating, abgekürzt ARIP). Es ist mehr als nur eine Addition von Vorteilen, da zum Ionenplattieren nicht nur Edelgasionen, sondern überwiegend Ionen des Beschichtungsmaterials zur Verfügung stehen.

Der Vorteil des bekannten Verfahrens liegt nicht zuletzt darin, daß es ein Ionenplattieren mit Metallionen und ein Ionenätzen mit Edelgasionen ermöglicht. Beim Ätzen werden die Substrate bevorzugt mit Argonionen beschossen. Sie werden in der Niedervoltbogenentladung erzeugt. Durch Anlegen einer negativen Vorspannung werden aus dem Plasma der Niedervoltbogenentladung herausdiffundierende Ionen in einem elektrischen Feld in Richtung auf die Substrate beschleunigt.

Der Nachteil des bekannten Verfahrens liegt in seiner Begrenzung auf Metalle, die bei Temperaturen unter etwa 1700°C verdampfen bzw. sublimieren. Titan und Chrom sind die wichtigsten Metalle, die mit Hilfe eines Niedervoltbogens aus einem Tiegel verdampft werden können. Ein weiterer Nachteil dieses Verfahrens ist die Beschränkung auf reine Metalle. Das stöchiometrische Verdampfen von Legierungen, z.B. von Titan-Aluminium zur Herstellung von TiAlN-Schichten, bereitet Schwierigkeiten.

Funkenverdampfer sind in ihren Vor- und Nachteilen komlementär zum Niedervoltbogenverdampfer. Sie können zwar Legierungen verdampfen und sie ermöglichen das Ionenplattieren mit Metallionen, sie ermöglichen aber auch nur das Ätzen mit Metallionen. Das Ätzen mit Edelgasionen hat sich aber eindeutig besser bewährt als das Ätzen mit Metallionen. Mit der erfolgreichen Einführung von ternären Verschleißschutzschichten aus Legierungen wie TiAlN kam der Wunsch auf, Funkenverdampferanlagen mit einem Niedervoltbogen zum Ätzen auszurüsten, um die Vorteile dieser Verfahren zu kombinieren. Eine solche Kombination und ihre Vorteile gegenüber dem herkömmlichen Metallionenätzen werden in dem Gebrauchsmuster DE 29615190 beschrieben.

Gemäß DE 29615190 durchdringt die Niedervoltbogenentladung nicht den zentralen, von den Substraten gebildeten Hohlraum, sondern sie brennt in einer besonderen Entladungskammer an der Außenwand der Bearbeitungskammer. Mit dieser Anordnung soll eine Einschränkung der Wirtschaftlichkeit des oben beschriebenen Verfahrens nach DE 2823876 vermieden werden. Zitat: "Diese Einschränkung kommt dadurch zustande, daß die Niedervoltbogenentladung, welche die Bearbeitungskammer zentral durchdringt, für sich eine gewisse Ausdehnung beansprucht und um gute und reproduzierbare Ergebnisse zu erhalten, die Werkstücke entsprechend von der Entladung beabstandet sein müssen, womit ein großer Teil des zentralen Raumes der Bearbeitungskammer nicht genutzt werden kann." Für die neue Ätzeinrichtung wird ein Abstand von 15 bis 25 cm empfohlen.

Die Ätzeinrichtung nach DE 29615190 hat einen großen Nachteil: Die in dem Gebrauchsmuster angestrebte Erhöhung der Wirtschaftlichkeit wird in der Praxis nicht erreicht. Der Grund liegt in der Gefahr, daß Funken entstehen und auf den Substraten Spuren hinterlassen. Wenn solche Defekte vermieden werden sollen, darf nur ein begrenzt hoher Ionenstrom auf die Substrate gezogen werden.

Die vorliegende Erfindung löst nicht nur dieses Problem, sondern die folgende, wesentlich weitergehende Aufgabe:

Schaffung einer Niedervoltbogenätzeinrichtung, die sich eignet

(1) für die Kombination mit verschiedenen Typen von Beschichtungsquellen,
(2) für feinstrukturierte 3-dimensionale Substrate und
(3) für kurze Ätzphasen.

Diese Aufgabe wird erfindungsgemäß dadurch gelöst, daß die Substrate wie bei dem Verfahren nach DE 2823876 um einen Hohlraum herum angeordnet und mittels Ionen aus einer sich von einer Glühkathode in einer Kammer durch eine Öffnung in den Behandlungsraum und dort in den Hohlraum bis zu einer Anode erstreckenden Niedervoltbogenentladung behandelt werden. Dabei wird während des Betriebs laufend Edelgas in die Glühkathodenkammer eingeführt und im Behandlungsraum durch Pumpen ein für den vorgesehenen Behandlungsprozeß hinreichendes Vakuum aufrechterhalten. Im Gegensatz zu dem Verfahren nach DE 2823876 wird aber das Plasma der durch die Öffnung eingeschnürten Entladung nicht daran gehindert, sich in dem Hohlraum bis zu den Substraten auszudehnen,
sondern das Plasma der durch die Öffnung eingeschnürten und sich zwischen der Öffnung und der Anode ohne Behinderung durch ein Magnetfeld ausdehnenden Entladung wird nur durch die Substrate und ihre Halterung auf der Innenseite des Hohlraums begrenzt.

Die gebräuchliche Methode, eine Gasentladung an ihrer Ausdehnung zu hindern, ist ein Magnetfeld, dessen Feldlinien parallel zur Entladung verlaufen. Ein solches Feld mit der Flußdichte B zwingt Elektronen (Masse m, Elementarladung e) mit einer radialen Geschwindigkeitskomponente $v_r$ auf schraubenförmige Bahnen mit dem Radius r = (m·$v_r$)/(e·B). Eine alternative Methode wäre ein Führungsrohr mit negativ geladenen Wänden oder mit elektrisch isolierenden bzw. isolierten Wänden, die sich durch das Plasma von selbst negativ aufladen. Der Vollständigkeit halber soll hier noch die bündelnde Wirkung des vom Plasmastrom selbst erzeugten Magnetfelds (Pinch-Effekt) erwähnt werden. Dieser Effekt kann grundsätzlich nicht verhindert werden, er bleibt aber bei fehlender magnetischer Bündelung in dem hier beschriebenen Zusammenhang ohne erkennbare Auswirkung.

Die erfindungsgemäße Vermeidung jeder vermeidbaren Behinderung der Ausdehnung des Plasmas bis zu den Substraten führt dazu, daß die den Hohlraum bildenden Substrate, wenn sie gegenüber dem Plasma ausreichend negativ geladen oder wenigstens elektrisch isoliert sind, selbst diese Wände bilden. Der Hohlraum wird so zu einer Art Plasmabehälter. Die Ausdehnung der Niedervoltbogenentladung kann beim Ausschalten des bündelnden Magnetfeldes durch ein Fenster im Vakuumrezipienten beobachtet werden.

Bei ausreichender Stromstärke der Niedervoltbogenentladung dringt das Plasma in die dreidimensionalen Strukturen der Substrathalterung und der einzelnen Substrate ein. Als Folge davon wird beim Ätzen und beim Ionenplattieren von komplex geformten Substraten eine gleichmäßigere Behandlung der Oberfläche erzielt. Man kann diesen Vorteil mit bloßem Auge erkennen, wenn man Substrate betrachtet, die nach dem Heizen Anlauffarben aufweisen. Wenn das Eindringvermögen des Plasmas nicht ausreicht, erkennt man nach dem Ätzen auf dem Grund von Bohrernuten oder anderen Vertiefungen die Anlauffarben der nicht abgeätzten Oxidschichten. Sie führen zu einem unzureichenden Haftvermögen der darauf abgeschiedenen Schichten.

Die praktische Beobachtung, daß das Eindringvermögen eine kritische Größe sein kann, wird durch die folgende theoretische Überlegung unterstützt:

Der Abstand, aus dem Ionen eines Plasmas abgesaugt und auf die Substrate beschleunigt werden, kann mit Hilfe der Schottky-Langmuir-Raumladungsformel abgeschätzt werden (siehe z.B. das Lehrbuch Gerthsen, Kneser, Vogel: Physik, 15. Auflage, Seite 431, Formel 8.30). Sie liefert die raumladungsbegrenzte Stromdichte j als Funktion des Absaugabstands d und der Differenz U zwischen dem Elektroden- und dem Plasmapotential. Für eine ebene Elektrode ist

$$d^2 = 4/9 \cdot \epsilon_0 \cdot (2e/M)^{1/2} \cdot U^{3/2}/j$$

mit $\epsilon_0$ = Dielektrizitätskonstante und e = Elementarladung.

Der mit dieser Formel berechnete Absaugabstand liegt bei dem erfindungsgemäßen Verfahren unter 1 mm. Wegen der komplizierten Geometrie ist das bestenfalls eine realistische Abschätzung. Sehr viel aussagekräftiger sind die mit der Schottky-Langmuir-Raumladungsformel berechneten Relativwerte. Die Rechnung zeigt insbesondere den Einfluß einer Erhöhung der Substratstromdichte auf das Eindringvermögen des Plasmas in geometrische Strukturen: Bei vorgegebener Leistung wird der Absaugabstand bei steigender Stromdichte überproportional verkleinert. Man erhält z.B. bei doppelter Stromdichte und halber Spannung trotz gleichbleibender Ätzrate einen um den Faktor 2,4 kleineren Absaugabstand. Das ist ein wichtiger Vorteil bei feinen und tiefen Strukturen, wie sie z.B. bei Spiralbohrern, Gewindebohrern, Fräsern, aber auch bei Press- und Stanzwerkzeugen vorkommen.

Im folgnden wird erläutert, warum durch das erfindungsgemäße Verfahren nicht nur eine Steigerung der Qualität, sondern auch eine Steigerung der Ätzrate erzielt werden kann:

Funken sind Bogenentladungen. Sie überziehen, im Gegensatz zu den Glimmentladungen, keine ausgedehnte Kathodenfläche, sondern schaffen sich einen kleinen, heißen, sich ständig bewegenden Kathodenfleck. Die Eigenschaften von Funken werden deshalb nicht durch die Stromdichte, sondern durch den Gesamtstom bestimmt. Die Wahrscheinlichkeit für das Zünden einer Funkenentladung wächst bei zunehmendem Gesamtstrom auf die Substrate stark an. Es gibt deshalb eine Stromgrenze bei etwa 10 A, die nicht überschritten werden sollte. Diese Stromgrenze gilt bei einer Aufteilung des Ätzstroms auf Teile der Substrathalterung nicht mehr für den Gesamtstrom, sondern für den Strom auf die einzelnen Teile. Die angestrebte Erhöhung der Ätzleistung mit der damit verbundenen Verkürzung der Ätzphase kann erreicht werden durch die Aufteilung des Ätzstroms auf alle einzelnen Bäumchen-Substrathalter und durch die Verwendung von den Strom begrenzenden Sicherungen in den Leitungen zu den einzelnen Bäumchen. Der erreichbare Verbesserungsfaktor entspricht dem Flächenverhältnis Hohlrauminnenseite/außen angesetzte Ätzeinrichtung.

Es ist bemerkenswert, daß die Aufgabe gerade durch die Nichteinhaltung der in der Patentschrift DE 2823876 formulierten, bisher allgemein anerkannten und praktisch eingehaltenen Lehre gelöst wurde, nämlich dadurch, daß die durch die Öffnung der Kammer eingeschnürte Niedervoltbogenentladung im Verdampfungsraum weder zusätzlich durch ein Magnetfeld auf die Anode geführt noch (zur Erzielung einer für die Verdampfung hinreichenden Leistungsdichte) auf der Oberfläche der Anode durch ein Magnetfeld gebündelt wird. Auch die in dem Gebrauchsmuster DE 29615190 aufgestellte Forderung nach einem Abstand zwischen den Substraten und der Entladung wird durch die vorliegende Erfindung nicht nur nicht eingehalten, sondern ins Gegenteil gekehrt.

Bei Versuchen zur Verdampfung von Material mit Hilfe des erfindungsgemäß nicht gebündelten Niedervoltbogens wurde dieser aus einer leistungsfähigeren Stromquelle gespeist, um die (nach geltender Lehre) für eine ausreichende Verdampfungsrate erforderliche Leistungsdichte zu erzielen. Bei diesen Versuchen zeigte sich, daß eine unerwartet kleine Erhöhung der Leistung des Niedervoltbogens ausreicht, um die gleiche Verdampfungsrate wie mit dem gebündelten Niedervoltbogen zu erreichen. Die durch Division der Gesamtleistung der Niedervoltbogenentladung durch die als Anode wirkende Oberfläche des Tiegels und des darin liegenden Materials berechnete Leistungsdichte liegt dabei deutlich unterhalb von 10 MW/m$^2$ (= 1 kW/cm$^2$), d.h. mehr als einen Faktor 10 unter der in der Patentschrift DE 2823876 angegebenen Untergrenze von 10 kW/cm$^2$.

Die Überraschung über dieses Ergebnis wurde noch gesteigert durch die scheinbar besonders ungünstigen geometrischen Bedingungen, unter denen die Versuche durchgeführt wurden: Der Abstand zwischen der Öffnung und dem zu verdampfenden Material kann ohne nachteilige Folgen bis an die geometrisch vorgegebenen Grenzen (0,7 m) der zur Verfügung stehenden Anlage gesteigert werden, ein Abstand, der bisher nur bei magnetischer Führung für möglich gehalten wurde.

Weitere Vorteile ergeben sich als direkte Folge aus dem Fehlen des Magnetfeldes und damit aus dem Wegfall der folgenden 3 Probleme:

(1) Das Magnetfeld bewirkt bei Substraten aus ferromagnetischen Materialien, z.B. bei Stahl- und Hartmetallwerkzeugen, eine permanente Magnetisierung. Solche Substrate müssen nach der Beschichtung in einem zusätzlichen Arbeitsgang entmagnetisiert werden. Bei leichten Substraten kann es sogar vorkommen, daß sie durch das Magnetfeld aus ihren Haltern gezogen werden. Noch störender ist die Rückwirkung von magnetisierbaren Substraten auf den Verlauf des Magnetfeldes und damit auf den Verlauf der Niedervoltbogenentladung.

(2) Vertikale und damit parallel zu den Feldlinien stehende Stützen aus magnetisch permeablem Stahl können zu einer Schwächung und/oder Verzerrung des Magnetfeldes führen. Diese Teile der Substrathalterung müssen deshalb aus teurerem und schwerer zu bearbeitendem austenitischem Stahl hergestellt werden. Da in der industriellen Praxis Substrathalterungen in großer Vielfalt verwendet werden und oft kurzfristig angefertigt werden müssen, hat dieser Nachteil wirtschaftliche Bedeutung.

(3) Auch die Magnetspulen selbst sind ein Problem. Sie sind meist außerhalb des Vakuumrezipienten angebracht. Außenliegende Magnetspulen sind aber entsprechend groß und bestimmen deshalb weitgehend das Konzept der Anlage, insbesondere des Vakuumrezipienten. Anlagen zur Durchführung des bekannten Verfahrens nach DE 2823876 haben deshalb meist einen für PVD-Anlagen ungewöhnlichen Aufbau: einen zylindrischen, mit Magnetspulen umschlossenen Rezipienten mit senkrechter Achse, bei dem die oft sehr schweren Substrathalter auf einem absenkbaren, im abgesenkten Zustand horizontal beweglichen Boden angeordnet sind. Innerhalb des Vakuumrezipienten befestigte Magnetspulen, wie sie in der Patentschrift DE 3615361 vorgeschlagen werden, würden auch die Verwendung von Rezipienten mit Fronttür zulassen. Obwohl solche Spulen kleinere Abmessungen haben, ist der mit ihnen verbundene Aufwand wegen der erforderlichen Hochvakuumtauglichkeit oder hochvakuumdichten Einkapselung der Spulen größer als bei außenliegenden Magnetspulen. Außerdem führen innenliegende Spulen entweder zu einer Behinderung der Dampfausbreitung oder zu einer Vergrößerung des Rezipienten.

Der Wegfall des 3. Problems ist besonders wichtig. Der technische Fortschritt liegt dabei weniger in der Einsparung des Aufwands für die Spulen (einschließlich Speisegerät und Steuerung), als vielmehr in dem Gewinn an Freiheit bei der Konstruktion einer neuen Anlage. Ein solcher Gewinn ist z.B. die Möglichkeit, einen Vakuumrezipienten mit Fronttür zu verwenden. Die Fronttür hat den Vorteil, daß sie in eine Wand integriert werden kann. Durch diese Maßnahme wird der ölfreie, aber oft staubige Arbeitsplatz des Beschichters von dem möglichst staubfreien, aber nicht ölfreien Maschinenraum getrennt. Auch wenn Flanschöffnungen auf den Wänden des Rezipienten angebracht werden müssen, z.B. für Funkenverdampfer oder Kathodenzerstäubungsquellen, ist es sehr hilfreich, wenn die Anlage nicht auch noch mit Spulen umgeben werden muß.

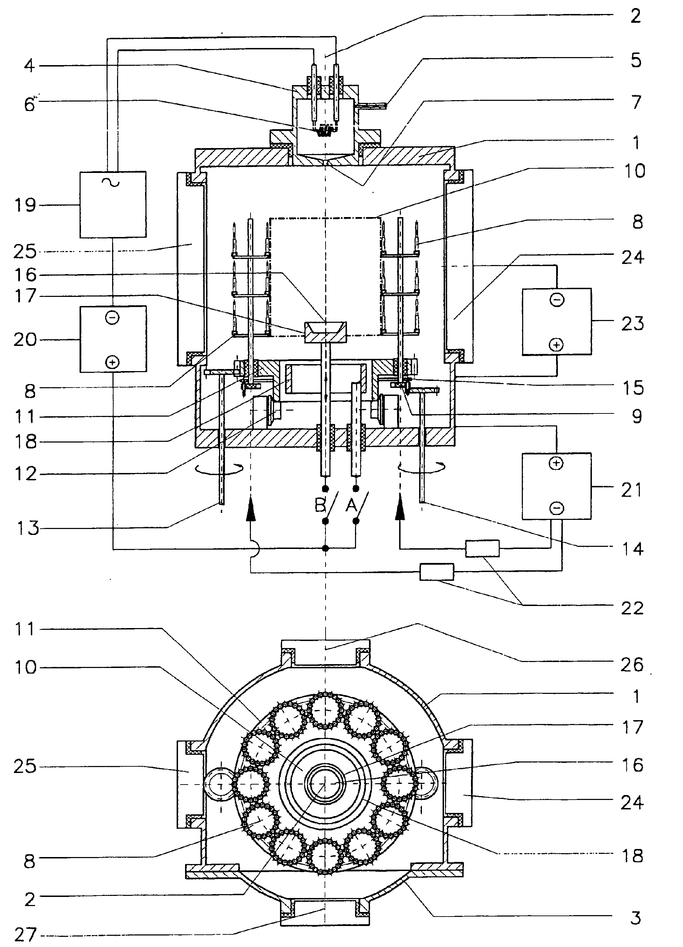

Im folgenden werden Beispiele bevorzugter Ausführungsformen des erfindungsgemäßen Verfahrens beschrieben. Diese Verfahrensbeispiele werden in einer als Beispiel gewählten bevorzugten Version der erfindungsgemäßen Anlage durchgeführt. Die Abbildung zeigt in schematischer Darstellung einen vertikalen Schnitt und im unteren Teil einen horizontalen Schnitt durch dieses Anlagenbeispiel.

Der Vakuumrezipient 1 hat die Form eines Zylinders um eine vertikale Achse 2. Er hat eine in voller Breite und Höhe angesetzten Fronttür 3. Die Anlage hat keine Spulen zur Erzeugung eines Magnetfeldes mit parallel zur Achse 2 gerichteten Feldlinien. Der Innenraum des Vakuumrezipienten 1 ist der Behandlungsraum. Er hat einen Durchmesser von 0,9 m. Auf den Innenwänden des Rezipienten 1 und der Tür 3 sind Strahlungsheizkörper befestigt. Sie sind in der Zeichnung nicht dargestellt. Auch die Hochvakuumpumpe ist nicht dargestellt. Oben auf dem Vakuumrezipienten 1 erkennt man die Kathodenkammer 4 mit dem Edelgaseinlaß 5. Die Kathodenkammer enthält die Glühkathode 6. Das ist ein durch Stromdurchgang geheizter Draht. Das Innere der Kathodenkammer 4 ist mit dem Behandlungsraum durch eine Öffnung 7 verbunden.

Die Substrathalterung umfaßt 12 Substrathalter, von denen in der Seitenansicht nur die in der Schnittebene liegenden Substrathalter gezeigt sind. Jeder Substrathalter ist elektrisch isoliert gelagert. In der Praxis handelt es sich meist um vertikale Wellen mit aufgesteckten Aufnahmen für Substrate. Die Substrathalter 8 werden wegen dieses Aussehens als Bäumchen bezeichnet. Jedes Bäumchen hat ein isoliertes Zahnrad 9 und kann sich um seine eigene Achse drehen. Die 12 Substrathalter 8 sind auf einem Kreis um die Achse 2 angeordnet und bilden zusammen eine axialsymmetrische Substratanordnung um einen axialsymmetrischen Hohlraum 10. Statt der 12 Bäumchen 8 mit 130 mm Durchmesser könnten auch 6 im Kreis angeordnete Bäumchen mit 260 mm Durchmesser den Hohlraum 10 bilden. Die vertikale Achse des von der Substratanordnung 8 geformten Hohlraums 10 ist identisch mit der Achse 2 des zylindrisch geformten Teils des Vakuumrezipienten 1.

Das um die Achse 2 drehbare Bauteil 11 der Substrathalterung ist das sog. Karussell. Es enthält die isolierenden Lager und die nicht dargestellten Stromzuführungen der Bäumchen. Das Karussell ist auf Rollen 12 gelagert und wird über die Welle 13 mit Hilfe eines Zahnrads angetrieben. Die Karusselldrehung dient (1) dem Ausgleich von azimutalen Unsymmetrien in der Plasmadichte oder in der Geometrie der Quellenanordnung, (2) dem Antrieb der Bäumchen über den Zahnring 15 und die Zahnräder 9 und (3) dem Transport der Bäumchen vor die Türöffnung zum Be- und Entladen. Wenn die Welle 14 und damit auch der Zahnring 15 festgehalten werden, dann sind die Drehbewegungen des Karussells und der Bäumchen gekoppelt. Wenn dagegen die Welle 13 festgehalten und die Welle 14 und damit auch der Zahnring 15 gedreht werden, dann steht das Karussell, und die Bäumchen drehen sich nur um ihre eigene Achse. Wenn beide Wellen gedreht werden, können die Drehbewegungen des Karussells und der Bäumchen beliebig eingestellt werden.

In dem von den zwölf Haltern gebildeten Hohlraum 10 befindet sich im zentralen Bereich um die Achse 2 ein vertikal verschiebbarer, wassergekühlter, elektrisch isoliert eingebauter Verdampfertiegel 16. Sein Abstand zur Öffnung 7 der Kathodenkammer 4 kann über die gesamte Höhe der Substrathalterung und darüberhinaus variiert werden. Der Tiegel 16 ist nach oben offen und mit dem zu verdampfenden Material gefüllt. Die seitlichen Oberflächen 17 des Tiegels und der Hubstange werden von mitbewegten, auf Schwebepotential liegenden Rohren gegen das Niedervoltbogenplasma abgeschirmt. Diese Abschirmung begrenzt den Elektronenbeschuß auf das zu verdampfende Material. Sie ist wesentlich, der Einfachheit halber aber nicht dargestellt. Der Tiegel mit seiner rohrförmigen Abschirmung ist am unteren Ende des Hohlraums 10 von einer feststehenden Elektrode 18 umgeben. Sie dient beim Ätzen und beim nicht aktivierten Ionenplattieren mit Edelgasionen als Anode der Niedervoltbogenentladung.

Die Glühkathe 6 wird durch Wechselstrom auf Weißglut gebracht. Dieser Strom wird von dem Speisegerät 19 erzeugt. Letzteres ist Teil des erdfreien Niedervoltbogenstomkreislaufs mit dem Gleichstrom-Speisegerät 20. Es liefert bis zu 420 A. Als Anode der Niedervoltbogenentladung kann entweder die Ätzanode 18 oder, wenn Material aus einem Tiegel verdampft werden soll, der Tiegel 16 verwendet werden. Beim Ätzen ist der Schalter A, beim Bedampfen der Schalter B geschlossen.

Mit dem Speisegerät 21 werden die Substrathalter auf ein negatives Potential gelegt, um zwischen den Substraten und dem Plasma eine Vorspannung zu erzeugen. Sie beträgt beim Ätzen etwa 200 V, beim Beschichten weniger. Das Substratpotential wird, für jedes Bäumchen getrennt, über nicht dargestellte Schleifringe zuerst auf das Karussell und von dort auf die Bäumchen übertragen. Jede der 12 Leitungen enthält eine elektronische Sicherung 22.

Das Speisegerät 23 versorgt die seitlich angeflanschte Beschichtungsquelle 24. Wenn die Quelle 24 ein Funkenverdampfer ist, liefert das Speisegerät 23 z.B. 300 A bei einer Brennspannung von etwa 20 V. Wenn es sich um eine Kathodenzerstäubungsquelle handelt, liefert das Speisegerät 23 z.B. 20 A bei einer Brennspannung von etwa 400 V. Die Beschichtungsquellen 25 bis 27 haben je ein eigenes, nicht gezeichnetes, Speisegerät.

Beispiel 1:

Das erste Beispiel beschreibt ein Ätzverfahren, d.h. eine erfindungsgemäßes Behandlung von Substraten durch Beschuß mit Edelgasionen aus einer Niedervoltbogenentladung vor der Beschichtung.

Die Substrate sind Bohrer mit 6 mm Durchmesser aus Schnellarbeitsstahl (HSS) oder aus Hartmetall. Auf die Stämme der Bäumchen 8 werden pro Bäumchen 3 runde Scheiben und dazwischen Rohre als Abstandhalter gesteckt. Die Scheiben sind am Rand mit je 20 Aufnahmen für einzelne Bohrer versehen. Die Bohrer werden senkrecht (wie Kerzen) in die um ihre senkrechten Achsen drehbaren 12 x 3 x 20 = 720 Aufnahmen gesteckt, dann wird die Rezipiententür 3 geschlossen und der Rezipient 1 mit Hilfe von Vakuumpumpen luftleer gepumpt.

Nach Erreichen eines Restgasdrucks von 0,003 Pa werden die Werkzeuge auf bekannte Weise mit Hilfe von Strahlungsheizkörpern auf eine Temperatur von 400°C geheizt, um die Desorption von Wasser- und Luftmolekülen zu beschleunigen.

Während des Ätzens wird ein Argonfluß von 0,133 Pa·m$^3$/s (das sind 80 sccm, sccm = Standardkubikzentimeter pro Minute) durch die Leitung 5 in die Kathodenkammer 4 und von dort durch die Öffnung 7 in den Innenraum des Rezipienten 1 aufrechterhalten. Aus dem Rezipienten wird das Argon durch eine Hochvakuumpumpe abgepumpt. Dabei entsteht im stationären Zustand ein Druckgefälle von der Kathodenkammer zum Innenraum des Rezipienten 1. Der Argondruck im Rezipienten 1 beträgt 0,127 Pa.

Die Niedervoltbogenentladung kann gezündet werden, wenn die mit Hilfe des Speisegeräts 19 durch direkten Stromdurchgang geheizte Glühkathode 6 heiß, der Tiegel 16 unten und der Schalter A geschlossen ist. Auf ihrem Weg von der Glühkathode 6 zu der als Anode dienenden Elektrode 18 durchquert die Niedervoltbogenentladung den Hohlraum 10 der Substratanordnung und füllt ihn mit ihrem Plasma. Die Stromstärke beträgt 280 A und die Brennspannung 39 V.

Der Stromkreis des Niedervoltbogens liegt auf schwebendem Potential. Die Glühkathode 6 legt sich dabei auf etwa -19 V und die Anode 18 auf etwa +20 V. Das Plasmapotential der Niedervoltbogenentladung im Hohlraum 10 liegt annähernd auf 0 V. Diese und alle folgenden Potentialangaben beziehen sich immer auf das Potential des geerdeten Rezipienten 1.

Die Substrathalter mit den Bohrern werden mit Hilfe des Speisegeräts 21 auf ein Potential von -200 V gelegt. Dadurch entsteht eine Vorspannung von -200 V zum Plasma, die aus dem Plasma herausdiffundierende positive Argonionen absaugt und zu den Substraten hin beschleunigt. Der Substratstrom ist fast unabhängig von der Vorspannung, aber stark abhängig vom Bogenstrom. Bei einem Bogenstrom von 280 A wird pro Bäumchen ein Substratstrom von etwa 1,8 A gemessen. Das sind insgesamt 21,6 A. Die Ätzphase dauert 15 Minuten. Funken werden nicht beobachtet.

Bei einer Vorspannung von -200 V beträgt die kinetische Energie der in Richtung Substrate beschleunigten Argonionen etwa 200 eV und die durch Ionenbeschuß auf die Substrate und ihre Halterung übertragene Leistung 4,32 kW. Diese Leistung bewirkt neben dem Ätzen eine zusätzliche Erwärmung der Substrate von 400°C auf etwa 420°C.

Die Ätzphase wird beendet durch Abschalten der Speisegeräte 20 und 19 des Niedervoltbogens und durch Abschalten der Argonzufuhr. Die in diesem Beispiel verwendeten Parameter führen zu einem guten Ätzergebnis. Wenn man den Prozeß nach dem Ätzen abbricht, kann man in den Bohrernuten keine Anlauffarben von nicht abgeätzten Oxidschichten erkennen. Die beschichteten Bohrer zeigen auch in der Nut keine Abplatzungen.

Diese Beobachtungen werden gestützt durch eine Abschätzung des Absaugabstands für Ionen aus einem Plasma. Die Schottky-Langmuir-Raumladungsformel liefert für Argonionen der Masse M = 40·1,67·10$^{-26}$ kg = 6,7·10$^{-26}$ kg bei U = 200 V und j = 21,6 A / 0,55 m$^2$ = 39,3 A/ m$^2$ einen Absaugabstand d ≈ 0,78 mm. In dieser Rechnung wird die Mantelfläche des von den Bäumchen gebildeten Hohlraums mit etwa 0,44 m Durchmesser und 0,4 m Höhe als stromziehenden Fläche von 0,55 m$^2$ eingesetzt.

Das beschriebene Ätzverfahren eignet sich zur Vorbereitung aller in der beschriebenen Anlage durchführbaren Beschichtungen. Es folgen 3 Beispiele für bekannte Beschichtungsverfahren:

(1) Zur Herstellung von Titanaluminiumnitrid (TiAlN) mit Funkenverdampfern wird die Vorspannung reduziert und Stickstoff als Prozeßgas in den Behandlungsraum eingelassen. Danach können bis zu 4 Funkenverdampfer 24 bis 27 eingeschaltet werden. Bei voller Bestückung dauert die Herstellung einer 3 µm dicken TiAlN-Schicht etwa 1 Stunde.

(2) Zur Herstellung einer Schichtenfolge aus TiAlN und Titannitrid (TiN) mit Funkenverdampfern wird der Funkenverdampfer 24 mit einer Ti-Kathode und der Funkenverdampfer 25 mit einer TiAl-Kathode ausgerüstet. Bei schneller Drehung der Welle 14 und des Rings 15 und langsamer Drehung der Welle 13 entsteht auch bei gleichzeitigem Betrieb der beiden Funkenverdampfer eine Wechselschicht mit scharfen Grenzflächen.

(3) Zur Herstellung einer Schicht aus Molybdändisulfid ($MoS_2$) mit einer Kathodenzerstäubungsquelle wird die Argonzufuhr beibehalten und ein planares Magnetron mit $MoS_2$-Kathode in Betrieb genommen.

Beispiel 2:

Das zweite Beispiel beschreibt ein Ionenplattierverfahren, d.h. eine erfindungsgemäße Behandlung von Substraten durch Beschuß mit Edelgasionen aus einer Niedervoltbogenentladung während einer Beschichtung mit Aluminiumoxid ($Al_2O_3$) mit Hilfe von Kathodenzerstäubungsquellen.
Als Kathodenzerstäubungsquellen werden 4 planare Magnetrons mit Aluminiumkathoden verwendet.
Die Substrate, Substrathalterung, Pumpen und Ätzen entsprechen der Beschreibung im ersten Beispiel. Der Übergang vom Ätzen zum Ionenplattieren wird so kontinuierlich wie möglich gestaltet: Der Anodenstrom von 280 A, der Argoneinlaß von 0,133 Pa·$m^3$/s und der dadurch erzeugte Argonpartialdruck von 0,127 Pa werden beibehalten.
Änderung der Substratvorspannung: Die Spannung des Speisegeräts 21 wird mit einer Mittelfrequenz von z.B. 10 kHz gepulst und die Amplitude auf 20 V reduziert.
Änderung der Gaszuführung: Zur Herstellung von Oxiden wird Sauerstoffgas durch eine speziell dazu geeignete, heiße Anode 18 in den Behandlungsraum eingelassen. Der schon als Gasmolekül reaktionsfreudige Sauerstoff wird durch die Gasentladung zusätzlich dissoziiert und angeregt. Der so aktivierte Sauerstoff reagiert beim ersten Stoß mit einer Metallwand. Der Sauerstofffluß wird so dosiert, daß das Aluminium auf den Substraten oxidiert wird und trotzdem die Kathoden der Magnetrons in den Bereichen erhöhter Abtragung metallisch bleiben.
Das negative Substratpotential erzeugt zusammen mit dem auf etwa +25 V liegenden Plasmapotential eine mittlere Vorspannung von etwa 45 V. Aus dem Plasma herausdiffundierende positiv geladene Edelgasionen treffen also mit einer mittleren kinetischen Energie von etwa 45 eV auf die Substrate. Der auf die Gesamtheit der 12 Bäumchen fließende Substratstrom beträgt etwa 21 A.
Ob es gelingt, die bekannten Ionenplattiereffekte auch bei dreidimensional strukturierten Substraten gleichmäßig auf der ganzen Oberfläche hervorzurufen, hängt, wie beim Ätzen, vom Eindringvermögen des Plasmas in die geometrischen Strukturen der Substrate ab. Die Schottky-Langmuir-Raumladungsformel liefert für Argonionen der Masse $M = 40 \cdot 1{,}67 \cdot 10^{-27}$ kg $= 6{,}6 \cdot 10^{-26}$ kg bei U = 45 V und j = 21 A / 0,55 $m^2$ = 38 A/m2 einen Absaugabstand von d ≈ 0,26 mm.
Ein vergleichbares Verfahren ist Gegenstand der Patentschrift WO 94/14996. Obwohl der Spulenstrom und damit das Magnetfeld versuchsweise ausgeschaltet wurde, wurden die sich daraus ergebenden Vorteile nicht erkannt (Seiten 20 bis 22, Versuche Nr. 6 und 7). Der Anspruch 34 betrifft im Unterschied zur Erfindung Merkmale zur Steuerung der Bündelung des Plasmastrahls und zeigt in Verbindung mit den Messungen und Kommentaren auf den Seiten 20 bis 22 der Beschreibung, daß die Beeinflussung des Plasmas durch Magnetspulen für wesentlich gehalten wird.
Ähnlich verhält es sich mit der in der Patentschrift EP 0306612 beschriebenen Kombination von Kathodenzerstäubung und Tiegelverdampfung gemäß DE 2823876, bei der die Niedervoltbogenentladung durch Magnetspulen fokussiert wird.

Beispiel 3:

Das dritte Beispiel beschreibt ein ARIP-Verfahren, d.h. eine erfindungsgemäße Behandlung von Substraten durch Beschuß mit Metallionen aus einem Niedervoltbogenverdampfer während einer Beschichtung mit TiN.
Substrate, Substrathalterung, Pumpen und Ätzen entsprechen der Beschreibung im ersten Beispiel. Der Übergang vom Ätzen zum Ionenplattieren wird so kontinuierlich wie möglich gestaltet: Der Argoneinlaß von 0,133 Pa·m3/s und der dadurch erzeugte Argon-Partialdruck von 0,127 Pa werden beibehalten.
Änderung der elektrischen Schaltung und Parameter: Die Spannung des Speisegeräts 21 wird auf 25 V reduziert. Der Tiegel 16 wird durch Schließen des Schalters B als Anode hinzugeschaltet und dann die Elektrode 18 durch Öffnen des Schalters A abgeschaltet. Die Glühkathode 6 wird geerdet, indem der Ausgang des Speisegeräts 19 mit dem Rezipienten verbunden wird. Die Stromstärke der Niedervoltbogenentladung wird von 280 A auf 420 A erhöht.
Änderung der Gaszuführung: Zur Herstellung von TiN wird Stickstoffgas direkt in den Behandlungsraum eingelassen. Der Stickstofffluß wird so lange erhöht, bis sich zusätzlich zu dem vorhandene Argondruck von 0,127 Pa ein Stickstoffparialdruck von 0,04 Pa und damit ein Totaldruck von 0,167 Pa einstellt. Dieser Zustand erfordert bei der vorhandenen Hochvakuumpumpe einen Stickstoffluß von etwa 150 sccm.

Das zu verdampfende Material liegt in dem Tiegel 16. Er hat einen Durchmesser von 80 mm. Um auf den Bohrern in allen 3 Etagen eine gleichmäßige Schichtdicke und Temperatur zu erzielen, wird der Tiegel im Bereich des Hohlraums 10 entlang der Achse 2 langsam auf und ab bewegt.

Die Niedervoltbogenentladung brennt zwischen der Glühkathode 6 und dem zu verdampfenden Material im Kupfertiegel 16. Das Plasma der Niedervoltbogenentladung breitet sich innerhalb des Hohlraums 10 der Substratanordnung frei aus. Die Bogenspannung schwankt zwischen etwa 46 V (Tiegel oben) und 60 V (Tiegel unten). Der Mittelwert der Bogenleistung liegt bei 420 A x 53 V = 22,3 kW.

Die Leistungsdichte beträgt 443 W/cm$^2$, d.h. deutlich weniger als die in der Patentschrift DE 2823876 als Untergrenze angegebenen 10 kW/cm$^2$. Trotzdem werden pro Stunde etwa 30 g Titan verdampft.

Das Substratpotential von -25 V erzeugt zusammen mit dem auf etwa + 25 V liegenden Plasmapotential eine Vorspannung von etwa 50 V. Aus dem Plasma herausdiffundierende positiv geladene Ionen werden treffen also mit einer mittleren kinetischen Energie von etwa 50 eV auf die Substrate. Der auf die Gesamtheit der 12 Bäumchen fließende Substratstrom ändert sich im Rhythmus der Hubbewegung des Tiegels zwischen etwa 23 A (Tiegel oben) und 92 A (Tiegel unten). Der Substratstrom hat einen zeitlichen Mittelwert von etwa 57,5 A. Auch bei den Substratstommaxima von 92 A bleibt der Strom auf die einzelnen Bäumchen unter 8 A, so daß die Gefahr des Zündens von Funken auf den Substraten noch nicht besteht.

Ob es gelingt, die bekannten Ionenplattiereffekte auch bei dreidimensional strukturierten Substraten gleichmäßig auf der ganzen Oberfläche hervorzurufen, hängt, wie beim Ätzen, vom Eindringvermögen des Plasmas in die geometrischen Strukturen der Substrate ab. Die Schottky-Langmuir-Raumladungsformel liefert für Titanionen der Masse M = $48 \cdot 1{,}67 \cdot 10^{-27}$ kg = $8 \cdot 10^{-26}$ kg bei U = 50 V und j = 57,5 A / 0,55 m$^2$ = 105 A/m$^2$ einen Absaugabstand d $\approx$ 0,22 mm.

Die Beschichtungsphase dauert 2 Stunden. Nach dem Abschalten des Beschichtungsprozesses und dem Abkühlen der Charge wird der Rezipient mit Luft geflutet und dann geöffnet. Die Bohrer haben an den nicht abgedeckten Oberflächen eine etwa 3 $\mu$m dicke TiN-Schicht mit der für stöchiometrisches TiN (Atomzahlverhältnis 1:1) charakteristischen goldgelben Farbe.

Die Bohrer werden einem standardisierten Prüfverfahren unterworfen. Diese Prüfung erfolgt durch das Bohren von 24 mm tiefen Sacklöchern in einer Tafel aus 42CrMo4 bei einer Drehzahl von 1592 Umdrehungen/Minute. Die gemäß diesem Beispiel ionenplattierten Bohrer bewähren sich beim Bohrtest besser als gleiche Bohrer, die mit dem herkömmlichen Verfahren nach DE 2823876 ionenplattiert werden. Mit der 3 $\mu$m dicken TiN-Beschichtung können bis zur Zerstörung des Bohrers statt 300 mindestens 400 Löcher gebohrt werden.

**Patentansprüche**

1. Verfahren zum Behandeln von um einen Hohlraum herum angeordneten Substraten mittels Ionen aus einer sich von einer Glühkathode in einer Kammer durch eine Öffnung in den Behandlungsraum und dort in den Hohlraum bis zu einer Anode erstreckenden Niedervoltbogenentladung, wobei während des Betriebs laufend Edelgas in die Glühkathodenkammer eingeführt und im Behandlungsraum durch Pumpen ein für den vorgesehenen Behandlungsprozeß hinreichendes Vakuum aufrechterhalten wird, **dadurch gekennzeichnet, daß** das Plasma der durch die Öffnung eingeschnürten Entladung planmäßig zwischen der Öffung und der Anode ohne Behinderung durch ein Magnetfeld nur durch die Substrate und ihre Halterung auf der Innenseite des Hohlraums begrenzt wird, nicht daran gehindert wird, sich in dem Hohlraum bis zu den Substraten auszudehnen.

2. Verfahren nach Anspruch 1, **dadurch gekennzeichnet, daß** in dem Hohlraum die Feldstärke von Magnetfeldern, deren Feldlinien längs zur Niedervoltbogenentladung verlaufen, kleiner als 0,0005 Tesla gehalten wird.

3. Verfahren nach Anspruch 1 oder 2, **dadurch gekennzeichnet, daß** die Substrate auf ein gegenüber ihrem Schwebepotential negatives Potential gelegt und mit positiv geladenen Ionen aus der Niedervoltbogenentladung beschossen werden.

4. Verfahren nach Anspruch 3, **dadurch gekennzeichnet, daß** die Substrate vor ihrer Beschichtung durch Ionenbeschuß geätzt werden.

5. Verfahren nach 4, **dadurch gekennzeichnet, daß** unmittelbar nach dieser Behandlung Kathodenmaterial eines Funkenverdampfers verdampft wird und daß die Substrate mit dem verdampften Material beschichtet werden.

6. Verfahren nach Anspruch 5, **dadurch gekennzeichnet, daß** gleichzeitig mindestens zwei Materialien aus derselben Kathode verdampft und die Substrate mit einer Mischschicht überzogen werden.

7. Verfahren nach Anspruch 5 oder 6, **dadurch gekennzeichnet, daß** sich der Funkenverdampfer außerhalb des Hohlraums befindet.

8. Verfahren nach Anspruch 7, **dadurch gekennzeichnet, daß** unter Verwendung von mindestens zwei Funkenverdampfern verschiedene Materialien verdampft und die Substrate mit einer Schichtenfolge überzogen werden.

9. Verfahren nach einem der Ansprüche 5 bis 8, **dadurch gekennzeichnet, daß** die Eigenschaften der aufwachsenden Schicht durch Beschuß mit Ionen aus dem Funkenverdampfer während der Beschichtung beeinflußt werden.

10. Verfahren nach einem der Ansprüche 1 bis 4, **dadurch gekennzeichnet, daß** Kathodenmaterial einer Kathodenzerstäubungsquelle zerstäubt wird und daß die Substrate mit dem zerstäubten Material beschichtet werden.

11. Verfahren nach Anspruch 10, **dadurch gekennzeichnet, daß** gleichzeitig mindestens zwei Materialien aus derselben Kathode zerstäubt und die Substrate mit einer Mischschicht überzogen werden.

12. Verfahren nach Anspruch 10 oder 11, **dadurch gekennzeichnet, daß** sich die Kathodenzerstäubungsquelle außerhalb des Hohlraums befindet.

13. Verfahren nach Anspruch 12, **dadurch gekennzeichnet, daß** unter Verwendung von mindestens zwei Kathodenzerstäubungsquellen verschiedene Materialien zerstäubt und die Substrate mit einer Schichtenfolge überzogen werden.

14. Verfahren nach einem der Ansprüche 10 bis 13, **dadurch gekennzeichnet, daß** die Eigenschaften der aufwachsenden Schicht durch Beschuß mit Ionen aus der Kathodenzerstäubungsquelle während der Beschichtung beeinflußt werden.

15. Verfahren nach Anspruch 3 und nach einem der Ansprüche 10 bis 14, **dadurch gekennzeichnet, daß** die Eigenschaften der aufwachsenden Schicht durch Beschuß mit Ionen aus der Niedervoltbogenentladung während der Beschichtung beeinflußt werden.

16. Verfahren nach einem der Ansprüche 1 bis 4, **dadurch gekennzeichnet, daß** Material als Anode der Niedervoltbogenentladung geschaltet und durch Elektronen aus der Niedervoltbogenentladung beschossen, erhitzt, verdampft und ionisiert wird und daß die Substrate vom Hohlraum her mit diesem Material beschichtet werden.

17. Verfahren nach Anspruch 16, **dadurch gekennzeichnet, daß** auf der Oberfläche der Anode die Leistungsdichte kleiner ist als 10 MW/m$^2$.

18. Verfahren nach Anspruch 3 und 16 oder 17, **dadurch gekennzeichnet, daß** die Eigenschaften der aufwachsenden Schicht durch Beschuß mit Ionen aus der Niedervoltbogenentladung während der Beschichtung beeinflußt werden.

19. Verfahren nach einem der Ansprüche 5 bis 18 zur Herstellung von Schichten, die Atome aus der Gruppe Bor, Kohlenstoff, Silicium, Stickstoff enthalten, **dadurch gekennzeichnet, daß** wenigstens eine Art Atome aus dieser Gruppe dem Behandlungsraum als Bestandteil eines Reaktivgases zugeführt wird.

20. Verfahren nach Anspruch 19, **dadurch gekennzeichnet, daß** die Zusammensetzung des Schichtmaterials während der Beschichtung geändert wird.

21. Anlage zur Durchführung des Verfahrens nach einem der Ansprüche 1 bis 20, mit einer Achse (2) und einem diese Achse umgebenden, durch Substrathalter (8) und Substrate gebildeten Hohlraum (10) und einer sich durch die Öffnung (7) der Glühkathodenkammer in den Behandlungsraum und dort in den Hohlraum bis zu einer Anode erstreckenden Niedervoltbogenentladung, **gekennzeichnet durch** das Fehlen von Mitteln zur Erzeugung eines Magnetfeldes mit axial verlaufenden Feldlinien und **durch** ein den Hohlraum (10) bis zu den Substraten und Substrathaltern (8) ausfüllendes Plasma.

22. Anlage nach Anspruch 21, **gekennzeichnet durch** eine Tür zum Be- und Entladen auf der Frontseite des Vakuumrezipienten.

23. Anlage nach einem der Ansprüche 21 oder 22, **gekennzeichnet durch** eine aus kreisförmig um einen axialsymmetrischen Hohlraum herum angeordneten Substrathaltern bestehende, um die Achse drehbare Substrathalterung.

24. Anlage nach Anspruch 23, **gekennzeichnet durch** einen um die Achse der Substathalterung drehbaren Ring, der seinerseits drehbare Substrathalter antreibt.

25. Anlage nach Anspruch 23 oder 24, **gekennzeichnet durch** Substrathalter mit individuellen Leitungen, über die sie auf das negative Potential gelegt sind.

26. Anlage nach Anspruch 25, **gekennzeichnet durch** eine automatische Sicherung pro Leitung, die bei Überschreitung einer vorgewählten Stromstärke die Leitung für eine vorgewählte Totzeit unterbricht.

27. Anlage nach einem der Ansprüche 21 bis 26 zur Durchführung des Verfahrens nach einem der Ansprüche 7 bis 9, **gekennzeichnet durch** mindestens einen, außerhalb des Hohlraums befestigten, mit seiner Kathode auf die Außenseite der Substrathalterung gerichteten Funkenverdampfer.

28. Anlage nach einem der Ansprüche 21 bis 26 zur Durchführung des Verfahrens nach einem der Ansprüche 12 bis 15, **gekennzeichnet durch** mindestens eine, außerhalb des Hohlraums befestigte, mit ihrer Kathode auf die Außenseite der Substrathalterung gerichtete Kathodenzerstäubungsquelle.

29. Anlage nach einem der Ansprüche 21 bis 26 zur Durchführung des Verfahrens nach einem der Ansprüche 16 bis 18, **gekennzeichnet durch** mindestens einen parallel zur Achse beweglichen, als Anode schaltbaren, wassergekühlten Kupfertiegel.

## Claims

1. A process for the treatment of substrates which are arranged around a cavity, using ions from a low-voltage arc discharge which extends from a hot cathode in a chamber, through an opening into the treatment space and there into the cavity as far as an anode, noble gas being introduced continuously into the hot cathode chamber during operation and a vacuum which is sufficient for the intended treatment process being maintained in the treatment space by pumping, **characterized in that** the plasma of the discharge which is pinched through the opening and, according to plan, is limited only by the substrates and their mounts on the inside of the cavity without being hindered by a magnetic field, is not prevented from spreading in the cavity as far as the substrates.

2. The process according to Claim 1, **characterized in that** in the cavity, the field strength of magnetic fields whose field lines run lengthwise to the low-voltage arc discharge is kept at less than 0.0005 tesla.

3. The process according to Claim 1 or 2, **characterized in that** the substrates are placed at a negative potential relative to their floating potential, and are bombarded with positively charged ions from the low-voltage arc discharge.

4. The process according to Claim 3, **characterized in that** the substrates are etched by ion bombardment before they are coated.

5. The process according to Claim 4, **characterized in that**, directly after this treatment, cathode material from an arc source is evaporated, and the substrates are coated with the evaporated material.

6. The process according to Claim 5, **characterized in that** at least two materials from the same cathode are evaporated at the same time, and the substrates are covered with a mixed layer.

7. The process according to Claim 5 or 6, **characterized in that** the arc source is located outside the cavity.

8. The process according to Claim 7, **characterized in that** using at least two arc sources, different materials are evaporated, and the substrates are covered with a layer sequence.

9. The process according to one of Claims 5 to 8, **characterized in that** the properties of the layer which is growing are influenced during the coating by bombardment with ions from the arc source.

10. The process according to one of Claims 1 to 4, **characterized in that** cathode material from a cathodic sputtering source is sputtered, and the substrates are coated with the sputtered material.

11. The process according to Claim 10, **characterized in that** at least two materials are sputtered from the same cathode at the same time and the substrates are covered with a mixed layer.

12. The process according to Claim 10 or 11, **characterized in that** the cathodic sputtering source is located outside the cavity.

13. The process according to Claim 12, **characterized in that**, using at least two cathodic sputtering sources, different materials are sputtered and the substrates are covered with a layer sequence.

14. The process according to one of Claims 10 to 13, **characterized in that** the properties of the layer which is growing are influenced during the coating by bombardment with ions from the cathodic sputtering source.

15. The process according to Claim 3 and according to one of Claims 10 to 14, **characterized in that** the properties of the layer which is growing are influenced during the coating by bombardment with ions from the low-voltage arc discharge.

16. The process according to one of Claims 1 to 4, **characterized in that** material is connected as the anode of the low-voltage arc discharge and bombarded by electrons from the low-voltage arc discharge, heated, evaporated and ionized, and the substrates are coated with this material starting from the cavity.

17. The process according to Claim 16, **characterized in that** the power density on the surface of the anode is less than 10 MW/m$^2$.

18. The process according to Claim 3 and 16 or 17, **characterized in that** the properties of the layer which is growing are influenced during the coating by bombardment with ions from the low-voltage arc discharge.

19. The process according to one of Claims 5 to 18 for the production of layers which contain atoms from the group consisting of boron, carbon, silicon, and nitrogen, **characterized in that** at least one kind of atom from this group is fed to the treatment space as a constituent of a reactive gas.

20. The process according to Claim 19, **characterized in that** the composition of the layer material is varied during the coating.

21. A system for carrying out the process according to one of Claims 1 to 20, comprising an axis (2) and a cavity (10) which surrounds this axis and is formed by substrate holders (8) and substrates, and a low-voltage arc discharge which extends through the opening (7) of the hot cathode chamber into the treatment space and there into the cavity as far as an anode, **characterized by** the absence of means for generating a magnetic field having axially extending field lines, and by a plasma filling the cavity (10) as far as the substrates and substrate holders (8).

22. The system according to Claim 21, **characterized by** a door for loading and unloading on the front side of the vacuum container.

23. The system according to one of Claims 21 or 22, **characterized by** a substrate support which consists of substrate holders arranged in a circle around an axisymmetric cavity and can be rotated about the axis.

24. The system according to Claim 23, **characterized by** a ring which can be rotated about the axis of the substrate support, and in turn drives rotatable substrate holders.

25. The system according to Claim 23 or 24, **characterized by** substrate holders with individual lines, by means of which they are placed at the negative potential.

26. The system according to Claim 25, **characterized by** one automatic cutout per line, which disables the line for a preselected dead time when a preselected current intensity is exceeded.

27. The system according to one of Claims 21 to 26 for carrying out the process according to one of Claims 7 to 9, **characterized by** at least one arc source which is fastened outside the cavity and has its cathode directed at the outside of the substrate support.

28. The system according to one of Claims 21 to 26 for carrying out the process according to one of Claims 12 to 15, **characterized by** at least one cathodic sputtering source which is fastened outside the cavity and has its cathode directed at the outside of the substrate support.

29. The system according to one of Claims 21 to 26 for carrying out the process according to one of Claims 16 to 18, **characterized by** at least one water-cooled copper crucible which is movable parallel to the axis and can be connected as the anode.

**Revendications**

1. Procédé de traitement de substrats disposés autour d'une cavité au moyen d'ions issus d'une décharge en arc à basse tension s'étendant depuis une cathode incandescente dans une chambre à travers une ouverture dans la zone de traitement, et de là dans la cavité jusqu'à une anode, du gaz rare étant introduit en continu pendant le fonctionnement dans la chambre de la cathode incandescente, et un vide suffisant pour le processus de traitement prévu étant maintenu dans la zone de traitement par des pompes, **caractérisé en ce que** le plasma de la décharge rétrécie par l'ouverture est limité de façon programmée, entre l'ouverture et l'anode sans entrave par un champ magnétique, uniquement par les substrats et leur support sur la face interne de la cavité, ce qui ne l'empêche pas de s'étendre dans la cavité jusque vers les substrats.

2. Procédé selon la revendication 1, **caractérisé en ce que**, dans la cavité, l'intensité de champ des champs magnétiques dont les lignes de champs s'étendent le long de la décharge en arc à basse tension, est maintenue en dessous de 0,0005 Tesla.

3. Procédé selon la revendication 1 ou 2, **caractérisé en ce que** les substrats sont placés sur un potentiel négatif par rapport à leur potentiel flottant et sont bombardés d'ions chargés positivement issus de la décharge en arc à basse tension.

4. Procédé selon la revendication 3, **caractérisé en ce que** les substrats sont gravés avant leur revêtement par un bombardement ionique.

5. Procédé selon la revendication 4, **caractérisé en ce que** immédiatement après ce traitement, le matériau de cathode d'un évaporateur à étincelles est évaporé, et **en ce que** les substrats sont recouverts du matériau évaporé.

6. Procédé selon la revendication 5, **caractérisé en ce que**, simultanément, au moins deux matériaux de la même cathode sont évaporés, et les substrats sont recouverts d'une couche mixte.

7. Procédé selon la revendication 5 ou 6, **caractérisé en ce que** l'évaporateur à étincelles se trouve en dehors de la cavité.

8. Procédé selon la revendication 7, **caractérisé en ce que** l'utilisation d'au moins deux évaporateurs à étincelles permet d'évaporer différents matériaux, et les substrats sont recouverts d'une série de couches.

9. Procédé selon l'une quelconque des revendications 5 à 8, **caractérisé en ce que** les propriétés de la couche en phase vapeur sont influencées par le bombardement d'ions issus de l'évaporateur à étincelles pendant le revêtement.

10. Procédé selon l'une quelconque des revendications 1 à 4, **caractérisé en ce que** le matériau de cathode d'une source de pulvérisation de cathode est pulvérisé, et **en ce que** les substrats sont recouverts du matériau pulvérisé.

11. Procédé selon la revendication 10, **caractérisé en ce que**, simultanément, au moins deux matériaux de la même cathode sont pulvérisés, et les substrats sont recouverts d'une couche mixte.

12. Procédé selon la revendication 10 ou 11, **caractérisé en ce que** la source de pulvérisation de cathode se trouve en dehors de la cavité.

13. Procédé selon la revendication 12, **caractérisé en ce que** l'utilisation d'au moins deux sources de pulvérisation de cathode permet de pulvériser différents matériaux, et les substrats sont recouverts d'une série de couches.

14. Procédé selon l'une quelconque des revendications 10 à 13, **caractérisé en ce que** les propriétés de la couche en phase vapeur sont influencées par le bombardement d'ions issus de la source de pulvérisation de cathode pendant le revêtement.

15. Procédé selon la revendication 3 et selon l'une quelconque des revendications 10 à 14, **caractérisé en ce que** les propriétés de la couche en phase vapeur sont influencées par le bombardement d'ions issus de la décharge à arc à basse tension pendant le revêtement.

16. Procédé selon l'une quelconque des revendications 1 à 4, **caractérisé en ce que** le matériau en tant qu'anode de la décharge à arc à basse tension est commuté, et bombardé d'électrons de la décharge à arc à basse tension, chauffé, vaporisé et ionisé, et **en ce que** les substrats de la cavité sont recouverts de ce matériau.

17. Procédé selon la revendication 16, **caractérisé en ce que** la puissance volumique à la surface de l'anode est inférieure à 10 MW/m$^2$.

18. Procédé selon la revendication 3 et 16 ou 17, **caractérisé en ce que** les propriétés de la couche en phase vapeur sont influencées par le bombardement d'ions issus de la décharge à arc à basse tension pendant le revêtement.

19. Procédé selon l'une quelconque des revendications 5 à 18 pour fabriquer des couches contenant les atomes du groupe bore, carbone, silicium, azote, **caractérisé en ce que** au moins un type d'atome de ce groupe est amené à la zone de traitement en tant que composant d'un gaz réactif.

20. Procédé selon la revendication 19, **caractérisé en ce que** la composition du matériau de couche est modifiée pendant le revêtement.

21. Dispositif pour réaliser le procédé selon l'une quelconque des revendications 1 à 20, avec un axe (2) et une cavité (10) entourant cet axe, formée par des porte-substrats (8) et des substrats, et une décharge à arc à basse tension s'étendant à travers l'ouverture (7) de la chambre de cathode incandescente dans la zone de traitement, et de là dans la cavité jusqu'à une anode, **caractérisé par** l'absence de moyens pour produire un champ magnétique avec lignes du champ s'étendant axialement et par un plasma remplissant la cavité (10) jusqu'aux substrats et porte-substrats (8).

22. Dispositif selon la revendication 21, **caractérisé par** une porte de chargement et de déchargement sur la face avant du récipient de vide.

23. Dispositif selon l'une quelconque des revendications 21 ou 22, **caractérisé par** un porte-substrat pouvant tourner autour de l'axe, composé de porte-substrats disposés de façon circulaire autour d'une cavité axialement symétrique.

24. Dispositif selon la revendication 23, **caractérisé par** un anneau pouvant tourner autour de l'axe du porte-substrat, lequel entraîne de son côté des porte-substrats rotatifs.

25. Dispositif selon la revendication 23 ou 24, **caractérisé par** des porte-substrats avec des lignes individuelles au dessus desquelles ils sont placés sur le potentiel négatif.

26. Dispositif selon la revendication 25, **caractérisé par** une protection automatique par ligne, qui interrompt en cas de dépassement d'une intensité de courant présélectionnée la ligne pendant un temps mort présélectionné.

27. Dispositif selon l'une quelconque des revendications 21 à 26 pour réaliser le procédé selon l'une quelconque des revendications 7 à 9, **caractérisé par** au moins un évaporateur à étincelles fixé en dehors de la cavité, orienté avec sa cathode sur la face externe du porte-substrat.

28. Dispositif selon l'une quelconque des revendications 21 à 26, pour réaliser le procédé selon l'une quelconque des revendications 12 à 15, **caractérisé par** au moins une source de pulvérisation de cathode fixée en dehors de la cavité, orientée avec sa cathode sur la face externe du porte-substrat.

**29.** Dispositif selon l'une quelconque des revendications 21 à 26, pour réaliser le procédé selon l'une quelconque des revendications 16 à 18, **caractérisé par** au moins un creuset en cuivre refroidi par eau, commutable en tant qu'anode, mobile parallèlement par rapport à l'axe.